# EUROPEAN PATENT SPECIFICATION

(11) **EP 1 003 219 B1**
(45) Date of publication and mention of the grant of the patent: **28.12.2011**
(21) Application number: 99119420.0
(22) Date of filing: 30.09.1999
(51) Int. Cl.: H01L 27/108, H01L 21/8242

(54) **DRAM with stacked capacitor and buried word line**
DRAM Speicherzellenanordnung mit Stapel-Kondensator und vergrabener Wortleitung
Cellule DRAM à condensateur empilé et ligne de mot ensillonée

(30) Priority: 19.11.1998 US 195602
(43) Date of publication of application: 24.05.2000
(73) Proprietor: Qimonda AG, 81739 München (DE)
(72) Inventor: Rupp, Thomas S., Stormville, NY 12582 (US)
(74) Representative: Patentanwälte Westphal, Mussgnug & Partner

(56) References cited:
- US-A- 4 949 138
- US-A- 5 307 310
- US-A- 5 502 320
- US-A- 5 736 761

## Description

### Field of Invention

This invention relates to a dynamic random access memory (DRAM) that uses as the memory cell a series combination of a transistor and a storage capacitor, and more particularly, to a DRAM of the kind in which the storage capacitor is formed as a multilayer stack on the top surface of a semiconductor body (substrate, chip) in which has been formed the transistor.

### Background of the Invention

DRAMs of the kind described above have become one of the more important of the integrated circuit devices. Moreover, the trend is to memories of larger and larger capacities. To increase the capacity of a memory, it is important to increase the density and decrease the size of the memory cells that are used to form the memory.

In the typical DRAM, the memory cells of the memory are arranged in rows and columns in a semiconductor body (silicon chip, substrate) and binary digits (bits) are read-in and read-out of the individual cells by means of bit lines and word lines that typically are provided by conductive layers that run over the surface of the chip spaced apart by dielectric layers.

In a popular form of DRAM the transistors are formed in a silicon integrated circuit chip and the storage capacitors are formed as multilayer stacks over a top surface of the chip. As the density of memory cells has increased, it has become more difficult to locate such stacked capacitors on the surface while maintaining the necessary electric isolation between individual capacitors and between the capacitors and the bit and word lines, all of which are competing for space on the surface of the chip.

US 5,502,320 discloses a stacked capacitor memory device having a buried word line in a trench arranged between regions serving as source and drain of a memory MOSFET.

US 5,307,310 discloses a memory cell having a silicided word line.

### Summary of the Invention

The present invention seeks to reduce the competition for space between individual capacitors, and between the capacitors and the bit and word lines by burying the word lines that are normally above the surface of a semiconductor body (substrate, chip) into the interior of the semiconductor body. In particular, the word lines are buried below the storage capacitors and the bit lines. The space freed by so locating the word lines can be used to increase the separation that can be provided to the storage capacitors and the bit lines that still remain in the space above the semiconductor body surface.

This problem is solved by the memory cell of claim 1 and the method of claim 6.

The invention will be better understood from the following more detailed description taken in conjunction with the accompanying drawing.

### Brief Description of the Drawing

FIGS. 1-11 show cross sections of a semiconductor body (substrate, chip, silicon wafer) at different stages of formation of a pair of memory cells therein in accordance with the present invention; and
FIGS. 12, 13, and 14 show schematic top views of transistors, storage capacitors, word lines, and bit lines of a DRAM in accordance with the present invention.

### Detailed Description

It will be convenient to describe the invention with reference to a portion of a semiconductor body (chip, substrate), in which the memory is formed that is of a size sufficient to form a pair of memory cells. As is known, typically most of the processing of a DRAM is done on a wafer scale, after which the wafer is diced into individual chips of a single DRAM for the final steps of the processing.

The process will be described specifically with reference to the preparation of memory cells that use an n-channel metal-oxide semiconductor field effect (MOSFET), also denoted as an insulated gate field effect transistor (IGFET), as the transistor. To this end, there is first prepared a semiconductor body (silicon chip, substrate, workpiece) 10 that includes at least at a top surface 10A thereof. In an illustrative embodiment semiconductor body 10 is monocrystalline of p-type conductivity and can be a layer either as a well in a substrate of either p-type and n-type conductivity. Alternatively, the p-type layer can be formed as an epitaxial layer grown on a suitable substrate, either of silicon or an insulator.

It is usual to begin the processing by forming over a surface 10A of semiconductor body 10 a "PAD" layer 11A that typically includes an underlying layer of silicon oxide and an overlying layer of silicon nitride. The PAD layer 11A is shown as a single layer in the interest of simplicity. This PAD layer has been patterned to expose regions where there will be formed shallow trenches filled with a dielectric material, typically silicon oxide, that will serve to isolate the memory cells from one another. Oxide filled trenches 12 are shown at the two ends of the body 10. The shallow oxide filled trenches typically are about 2500 Angstroms deep and surround the active areas, typically of square or rectangular shape, in which are largely formed individual pairs of memory cells.

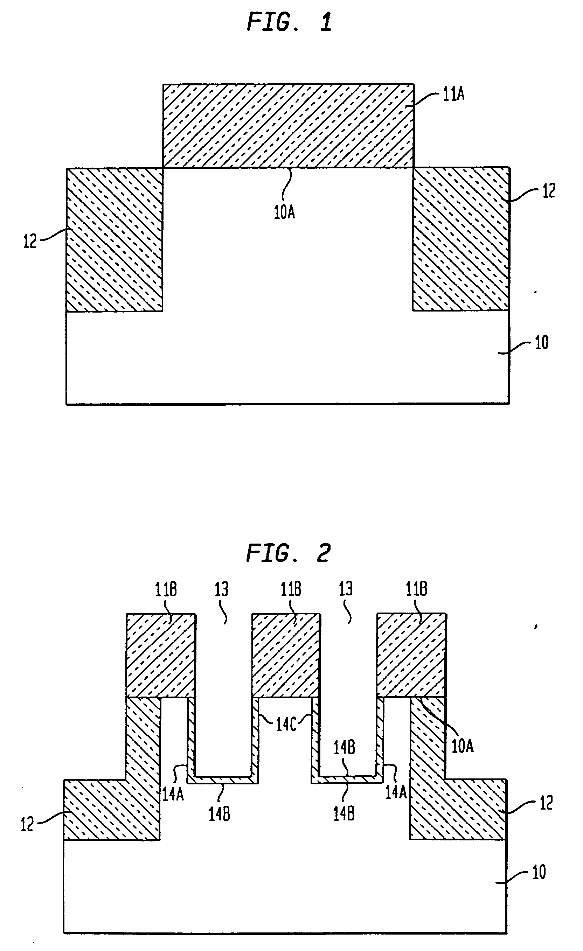

FIG. 2 shows the semiconductor body 10 has been etched to form vertical trenches 13 therein in a central region thereof and in the oxide-filled trenches 12. Typically this can be done by first removing the remainder of the original PAD layer 11A, forming a second PAD layer 11B over the surface, patterning it to form a mask that is used in a reactive ion etching (RIE) to define the vertical trenches 13 shown. The trenches 13 typically can be about 2000 Angstroms deep and those in the semiconductor body 10 eventually house buried word lines. The walls of the trenches 13 also will define the channels and the gate electrodes. To this end, a dielectric layer, suitable for use as the gate dielectric, and including two vertical segments 14A and 14C, and a horizontal segment 14B, is formed over sidewalls and a bottom of each trench 13. Before the growth of this oxide, the walls and bottom can be subjected to ion implantation to set separately the threshold voltage of each of the three channel portions that will be formed adjacent the three dielectric segments 14A, 14B, and 14C. Each of these three segments is be subjected to ion implantation from a different one of three different ion beam directions, making it possible to provide, if desired, a different threshold voltage V_{T} for each segment.

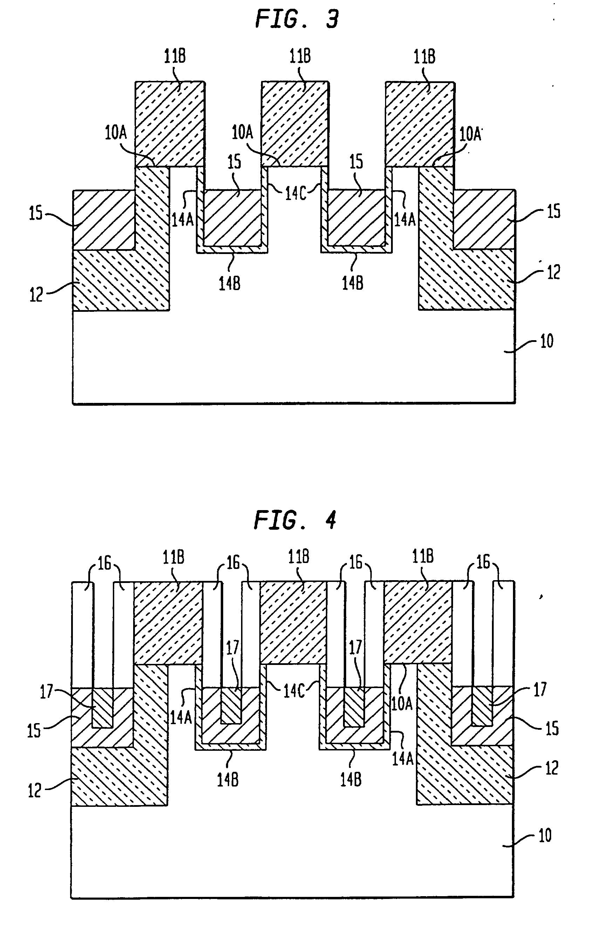

As is shown in FIG. 3, these shallow central trenches 13 have now been partially filled with doped polysilicon fill 15 that will serve as the gate conductors. As shown, the top level of the polysilicon fill is made to be below the level of the top surface 10A of the semiconductor body 10, typically about 500 Angstroms below, to insure that the word line remains buried below the top surface 10A of the semiconductor body 10. This typically can be accomplished by conformal deposition of the polysilicon to overfill the trenches 13 and then using reactive ion etching to form recesses in the fill to below the surface 10A.

FIG. 4 shows suitable spacers 16 formed over the sidewalls of the trenches 13 about 150 Angstroms thick. These can be formed by first filling the trenches 13 and then using reactive ion etching to form a central opening leaving the sidewall spacers 16. With the spacers 16 in place, there can now be formed a recess in each of the polysilicon fill 15 without disturbing the gate oxide layer 14A, 14B and 14C that is in place along the side walls and bottom of the gate conductor polysilicon fill 15 that will provide the word line.

Now each recess formed in the polysilicon gate conductors 15 is filled with fill 17 of a silicide, such as tungsten silicide, to increase the its conductivity for use as the word line. To this end, there typically needs first to fill each opening and then the excess is etched away. Care should be taken to keep the word line fill 17 sufficiently below the surface 10A, typically the 500 Angstroms mentioned earlier.

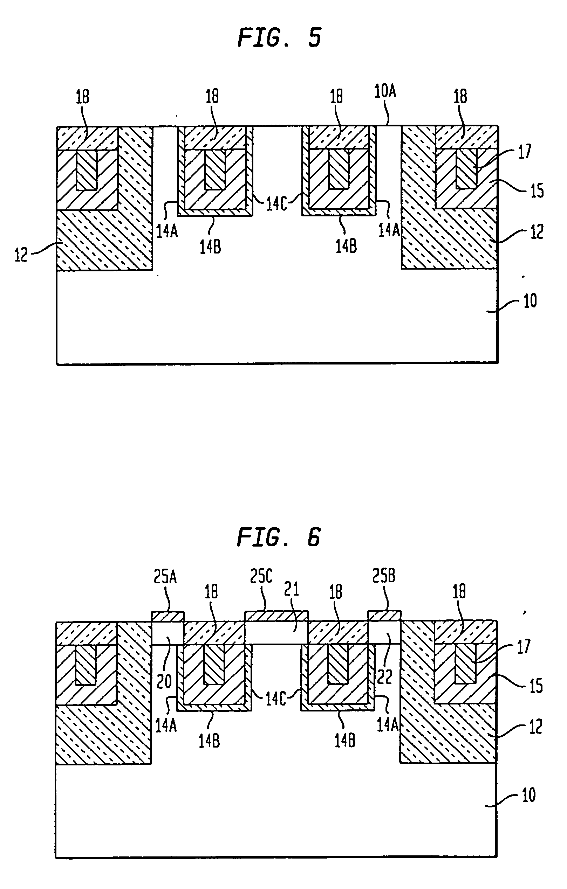

FIG. 5 shows the second PAD layer 11B and the spacers 16 have been stripped away, and the recess left by their removal filled with a dielectric, typically silicon oxide 18. This can be done by chemical vapor deposition (CVD) of silicon oxide to cover the surface and then chemical mechanical polishing (CMP) to planarize the surface using the monocrystalline silicon as an etch stop.

At this point, as is shown in FIG. 5, the word line, including the doped polysilicon 15 and silicide 17, is completely surrounded by dielectric from gate dielectric 14 or the new dielectric 18 and is located below the surface 10A, a main feature of the process of the present invention.

Alternatively, the result shown in FIG. 5 could have been obtained by stripping only the spacers 16, and removing the PAD layers 11B only after the oxide has been formed to the desired level, leaving the structure shown.

FIG. 6 shows n+ type conductivity regions 20, 21 and 22 have been formed just below the surface 10A of the semiconductor body 10. Generally, regions 20 and 22 will be described separate as sources and region 21 as the common drain for the two transistors being formed in one active area. However, as is known in a DRAM, the sources and drains of the transistor exchange roles during the read-in and read-out operations, but it is conventional to describe the region that is connected to the bit line as the drain and the region that is connected to the storage node of the storage capacitor as the source.

Also shown in FIG. 6 are n+ type conductivity epitaxial contact regions 25A, 25B, and 25C that have been respectively grown selectively over the monocrystalline silicon source/drain regions 20, 22, and 21, respectively, to provide further elevation and possible lateral expansion of these regions to simplify the provision of source and drain contacts. It can be appreciated that this step is optional.

Moreover, it can be appreciated that there is little need to limit the depth of the source and drain diffused regions since the effective depth of the source and drain regions can be controlled by the thickness of the oxide layer 18 that was provided over the gate conductors 15.

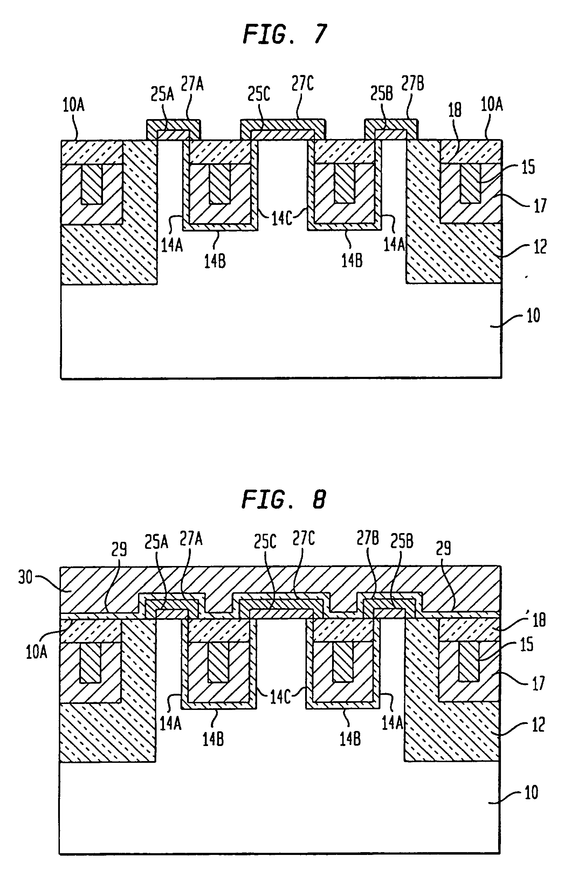

As is shown in FIG. 7, the source contacts 25A and 25B and drain contact 25C have been each surrounded by coatings 27A, 27B, and 27C, respectively, of a silicide, typically Ti or W silicide, to improve their conductivity. Because the elevated source and drain contacts 25A, 25B, and 25C are well defined, the silicide contacts are desirably self aligned (salizide contacts).

FIG. 8 shows stacked capacitors over the surface 10A of the semiconductor body 10. To this end, there is first deposited a dielectric layer 29 of a material with a high dielectric constant suitable for use as the dielectric of the storage capacitor, for example barium strontium titanate (BSTO), over the surface 10A to serve as the common dielectric layer of all the storage capacitors. This in turn is covered by a layer 30 of high conductivity metal that will serve as the upper or second plate of each storage capacitor of a memory cell in a memory area of semiconductor body 10. Peripheral areas which contain support circuitry for the memory cells are masked to prevent formation of layers 29 and 30 thereover. The second plate is typically kept at the ground or reference potential so that a single continuous layer of platinum can serve as the second plate of each storage capacitor in the DRAM. As has been discussed, the lower or first plate of the capacitors is provided by the individual raised salicidized contacts 25A and 25B, and 27A and 27B that also serve as the source contacts.

It is to be noted that the capacitor-source contacts have been formed essentially without the need for any patterned etching.

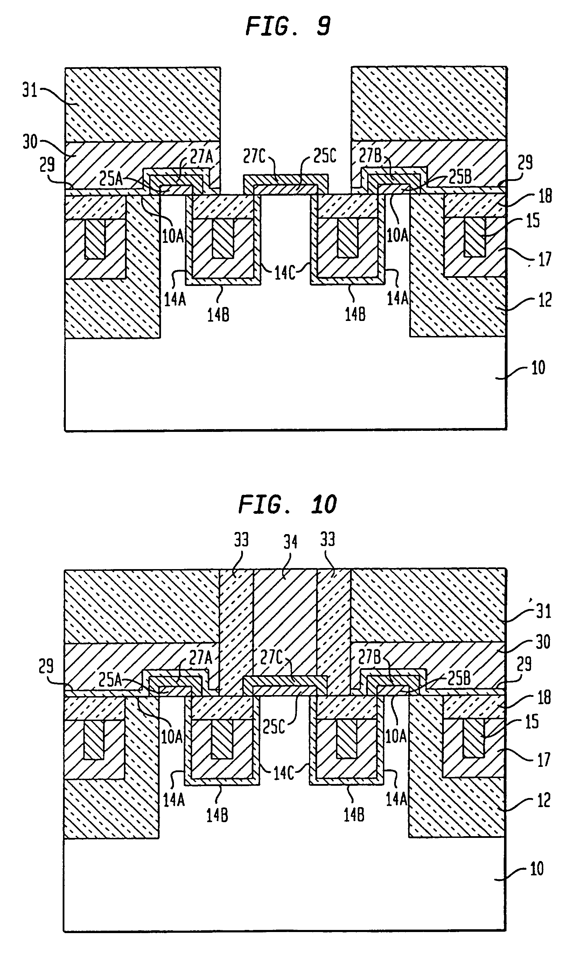

Now to achieve the result shown in FIG. 9, a dielectric cap, such as a layer 31 of boro-phosphide silicate glass (BPSG), has been deposited over the top of layer 30. In the peripheral areas of semiconductor body 10 a masking layer denoted above is first removed and then layer 30 is deposited over the peripheral areas at the same time it is deposited over the memory cell areas. Then a central portion of layers 31, 30, and 29 above semiconductor body 10 is removed by localized etching to leave exposed the salicidized drain contact 27C.

Now to achieve the result shown in FIG. 10, dielectric spacers 33 are provided over the sidewalls of the opening that had been formed in the BPSG. These typically are formed by filling the opening with a suitable spacer dielectric, such as silicon nitride, after which RIE is used to form an opening in the silicon nitride to leave the spacers 33. Now, the opening is overfilled with a suitable bit line contact material, such as doped polysilicon or a metal, after which the surface is planarized by CMP to leave the bit-line contact plug 34 in place.

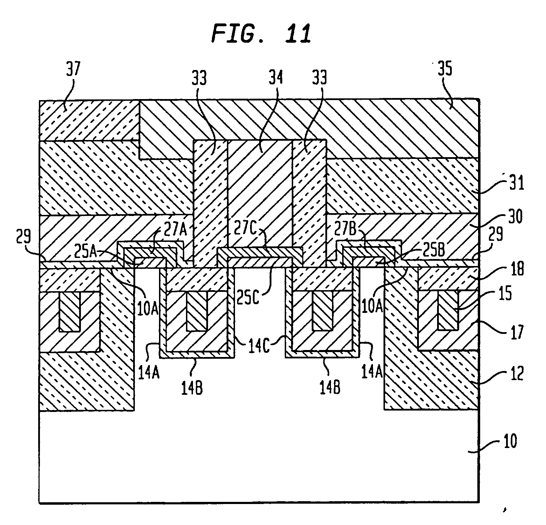

Next there is realized the result shown in FIG. 11 in which there has been added the bit line 35 making contact to the bit line contact plug 34. There can be first deposited and planarized the interlevel TEOS dielectric 37 over the top surface of the BPSG. Then the TEOS and the BPSG can be patterned and etched to a level below that of the contact plug 34, after which the wiring metal can be deposited and planarized also to achieve the result shown in FIG. 11. Alternatively, there is deposited and patterned the bit line wiring 35. Then there is deposited and planarized the layer 37 of the interlevel dielectric, typically the silicon oxide described as TEOS that has become popular in the art for this purpose.

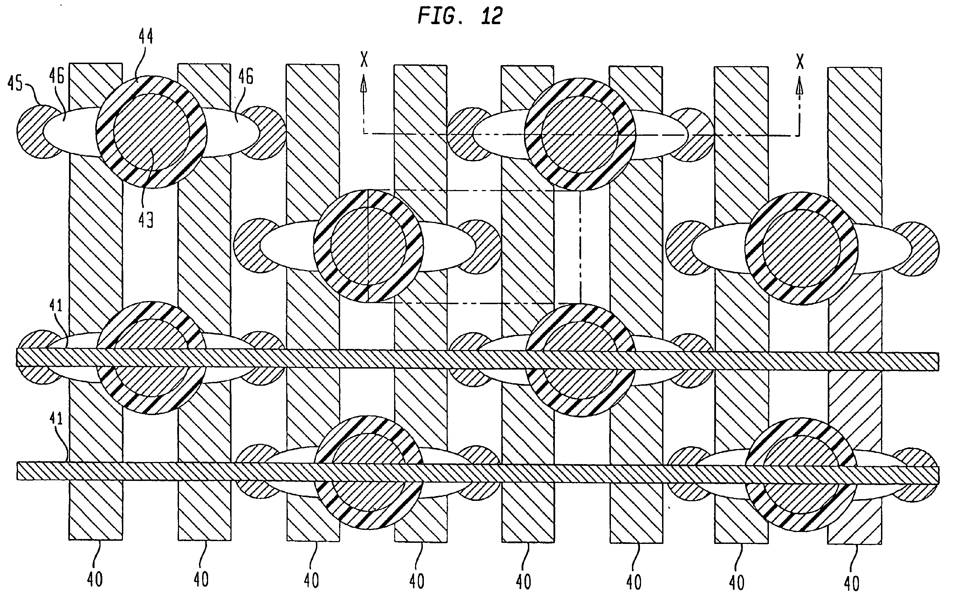

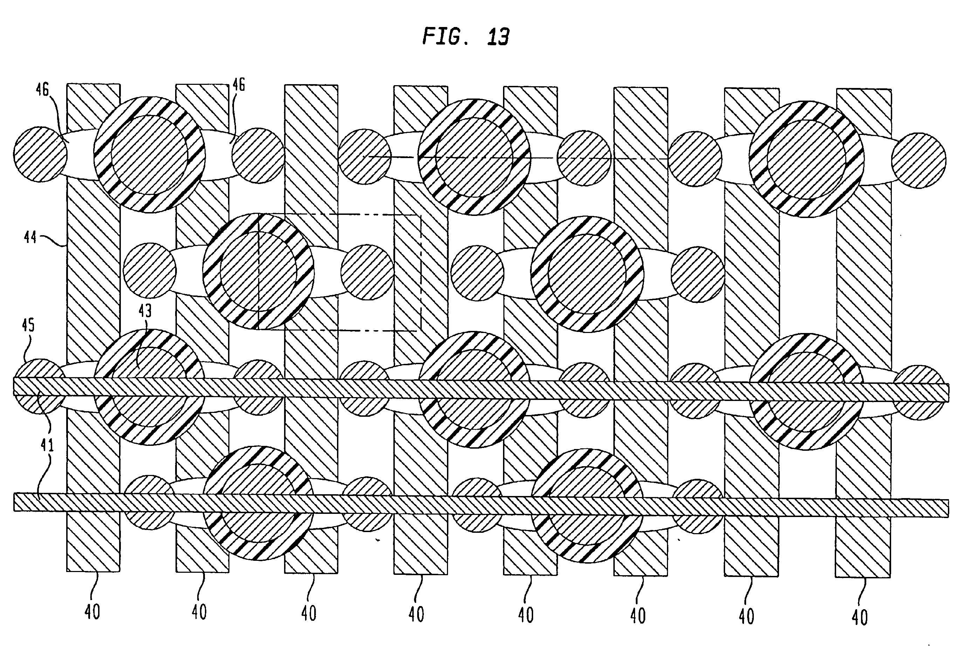

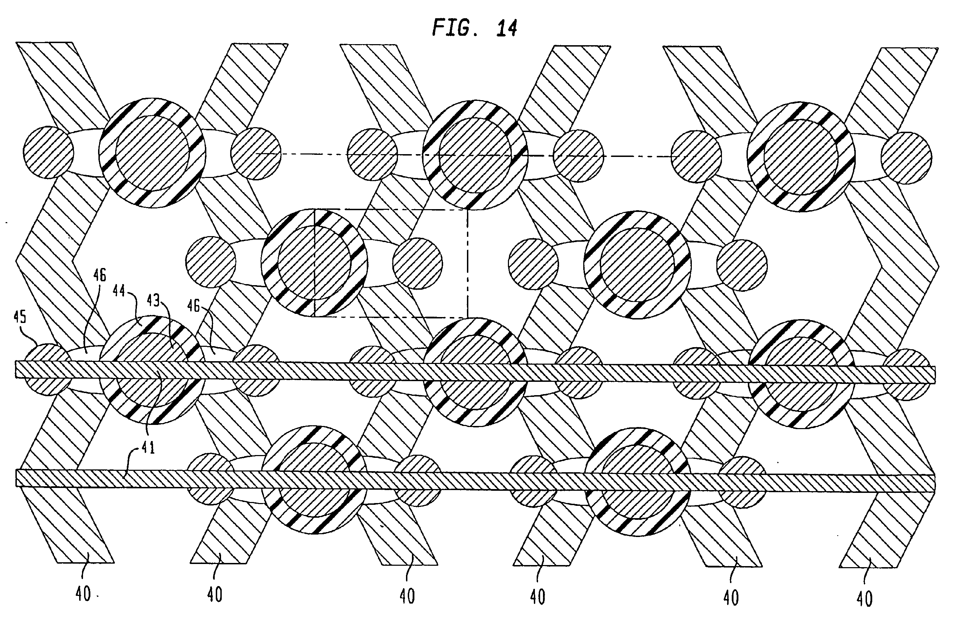

FIGS. 12, 13, and 14 are a top view illustrating various possible layouts of the memory cells of a memory array of a DRAM. In each of these figures the word lines 40 of which eight are shown in FIGS. 12 and 13 and six are shown in FIG. 14, extend vertically and the bit lines 41, of which only two are shown for purposes of simplification, extending horizontally. The location of the bit line contacts are shown by the inner circles 43 that are shown surrounded by the outer circles 44, representing spacer layers. The location of epitaxial grown silicon regions that serve as the lower plate of the storage capacitors are represented by the circles 45. Generally the shallow oxide-filled isolation trenches are excluded in areas 46.

The various cross-sections of FIGS. 1-11 essentially represent cross-sections taken along the dashed line X-X of FIG. 12.

It should be apparent that the specific embodiment described is merely illustrative of the general principles of the invention. In particular, it should be evident that the particular materials mentioned for use as the dielectric layers, spacer layers, and contacts can be varied. It is also evident that the complementary structure using p-channel transistors is feasible.

## Claims

1. A memory cell including a transistor in series with a storage capacitor for use in an array of memory cells that form a dynamic random access memory comprising:
a semiconductor body (10) of one conductivity type having a top surface (10A);
first and second regions of the opposite conductivity type of the semiconductor body suitable for serving as the source (20, 22) and drain (21) of the transistor and being formed in the semiconductor body (10) and being spaced apart by a portion of the semiconductor body and each having a portion thereof which includes a portion of the top surface (10A);
a trench (13) in the semiconductor body (10) in the region intermediate between the spaced apart regions, the trench (13) including a conductive fill (15), the level of the conductive fill (15) being below that of the top surface (10A) of the semiconductor body (10), the conductive fill (15) being electrically isolated from the surrounding semiconductor body (10) by a layer of a material (14A, 14B, 14C) suitable for serving as the gate dielectric of the transistor and including an overlying dielectric layer (18)that forms a planar surface with top surface (10A); and
a storage capacitor located over the semiconductor body (10) including a conductive layer (25A, 25B, 25C) over the source (20, 22) region to serve as the lower plate, a layer (29) of material suitable for a capacitor dielectric overlying the lower plate (25A, 25B, 25C), and a conductive layer (30) over the capacitor dielectric to serve as an upper plate;
wherein the source (20, 22) and drain (21) regions include a doped epitaxial silicon layer (25A, 25B, 25C) grown over the original surface of the semiconductor body (10) to serve as a lower plate of the storage capacitor.

2. The memory cell of claim 1 in which the conductive fill (15) of the trench is doped polysilicon and the surrounding dielectric (14A, 14B, 14C) is silicon oxide.

3. The memory cell of claim 2 in which the conductive fill (15) of the trench includes a silicide core (17).

4. The memory cell of claim 1 in which a layer of a silicide (27A, 27B, 27C) overlies the doped epitaxial silicon layer (25A, 25B, 25C).

5. The memory cell of claim 1
wherein said semiconductor body (10)is of monocrystalline silicon, and
wherein the trench (13) includes wall and bottom portions of doped polysilicon and a core region (17) of a highly conductive material, the core region (17) serving as a gate contact plug.

6. A method for forming a memory cell that includes a transistor and a storage capacitor comprising the steps of:
defining in a surface portion of a monocrystalline silicon wafer (10) an active area in which there is to be formed a switch transistor;
forming in an intermediate region of said surface portion a trench (13);
lining the trench (13) with a dielectric layer (14A, 14B, 14C) suitable for use as the gate dielectric of the transistor;
partially filling the trench (13) to a level below that of the top surface (10A) of the silicon wafer (10) with a conductive material (15) suitable for use as the gate electrode of the transistor;
forming a dielectric layer (18) over the trench (13) to fill the trench (13) essentially to the level of the top surface (10A) of the silicon wafer (10);
forming source (20, 22) and drain (21) regions in the silicon wafer (10) on opposite sides of the trench (13) of said silicon wafer (10);
forming an epitaxial layer (25A, 25B) of doped silicon over the source (20, 22) region for serving as the lower plate of the storage capacitor and forming an epitaxial layer (25C) of doped silicon over the drain (21) region for serving as a bit-line contact to the drain (21) region;
forming over the source (20, 22) region a layer (29) suitable for use as the dielectric layer of the storage capacitor; and
forming over said dielectric layer (29) of the storage capacitor a conductive layer (30) suitable for use as the upper plate of the capacitor.

7. The method of claim 6 in which the conductive material (15) suitable for use as the gate electrode comprises an inner core (17) of a silicide surrounded by doped polysilicon (15) .

8. The method of claim 6 in which the active area is defined by a surrounding trench filled with a dielectric material.

9. The method of claim 6 in which a pair of trenches are formed in the active area and a common drain (21) region is formed in the region intermediate between the two trenches and separate source (20, 22) regions are formed in the two regions outside the two trenches and each of the trenches is similarly filled.

10. The method of claim 9 in which the active area is defined by a surrounding isolation trench filled with silicon oxide.

11. The method of claim 9 in which each of the two trenches are similarly filled with an inner core (17) of a silicide and a surrounding layer of doped polysilicon (15).

12. The method of claim 6 in which each of the doped epitaxial silicon layers (25A, 25B, 25C) over the two source (22, 22) regions is covered with a dielectric layer (29) and a conductive layer (30) to form separate storage capacitors.

## Patentansprüche

1. Speicherzelle mit einem Transistor in Reihe mit einem Speicherkondensator zur Verwendung in einem Array von Speicherzellen, die einen dynamischen Direktzugriffsspeicher bilden, umfassend:
einen Halbleiterkörper (10) von einem Leitfähigkeitstyp mit einer oberen Oberfläche (10A);
erste und zweite Gebiete vom entgegengesetzten Leitfähigkeitstyp des Halbleiterkörpers, die geeignet sind, um als Sourceelektrode (20, 22) und Drainelektrode (21) des Transistors zu dienen und die in dem Halbleiterkörper (10) ausgebildet sind und durch einen Abschnitt des Halbleiterkörpers beabstandet sind und jeweils einen Abschnitt davon aufweisen, der einen Abschnitt der oberen Oberfläche (10A) enthält;
einen Graben (13) in dem Halbleiterkörper (10) in dem Gebiet zwischen den beabstandeten Gebieten, wobei der Graben (13) eine leitende Füllung (15) enthält, wobei die Höhe der leitenden Füllung (15) unter der der oberen Oberfläche (10A) des Halbleiterkörpers (10) liegt, wobei die leitende Füllung (15) elektrisch von dem umgebenden Halbleiterkörper (10) durch eine Schicht aus einem Material (14A, 14B, 14C) isoliert ist, die sich dazu eignet, um als das Gatedielektrikum des Transistors zu dienen und eine darüberliegende Dielektrikumsschicht (18) enthält, die mit der oberen Oberfläche (10A) eine planare Oberfläche bildet; und
einen Speicherkondensator, der sich über dem Halbleiterkörper (10) befindet, einschließlich einer leitenden Schicht (25A, 25B, 25C) über dem Gebiet der Sourceelektrode (20, 22), um als die untere Platte zu dienen, einer Schicht (29) aus Material, die sich für ein über der unteren Platte (25A, 25B, 25C) liegendes Kondensatordielektrikum eignet, und einer leitenden Schicht (30) über dem Kondensatordielektrikum, um als eine obere Platte zu dienen;
wobei die Gebiete der Sourceelektrode (20, 22) und der Drainelektrode (21) eine dotierte epitaxiale Siliziumschicht (25A, 25B, 25C), die über der ursprünglichen Oberfläche des Halbleiterkörpers (10) aufgewachsen ist, enthalten, um als eine untere Platte des Speicherkondensators zu dienen.

2. Speicherzelle nach Anspruch 1, bei der die leitende Füllung (15) des Grabens dotiertes Polysilizium ist und das umgebende Dielektrikum (14A, 14B, 14C) Siliziumoxid ist.

3. Speicherzelle nach Anspruch 2, bei der die leitende Füllung (15) des Grabens einen Silizidkern (17) enthält.

4. Speicherzelle nach Anspruch 1, bei der eine Schicht aus einem Silizid (27A, 27B, 27C) über der dotierten epitaxialen Siliziumschicht (25A, 25B, 25C) liegt.

5. Speicherzelle nach Anspruch 1
wobei der Halbleiterkörper (10) aus monokristallinem Silizium ist und
wobei der Graben (13) Wand- und Bodenabschnitte aus dotiertem Polysilizium und ein Kerngebiet (17) aus hoch leitendem Material enthält, wobei das Kerngebiet (17) als ein Gatekontaktplug dient.

6. Verfahren zum Ausbilden einer Speicherzelle, die einen Transistor und einen Speicherkondensator enthält, umfassend die folgenden Schritte:
Definieren eines aktiven Bereichs in einem Oberflächenabschnitt eines monokristallinen Siliziumwafers (10), in dem ein Schalttransistor ausgebildet werden soll;
Ausbilden eines Grabens (13) in einem Zwischengebiet des Oberflächenabschnitts;
Auskleiden des Grabens (13) mit einer Dielektrikumsschicht (14A, 14B, 14C), die sich zur Verwendung als das Gatedielektrikum des Transistors eignet;
teilweises Füllen des Grabens (13) zu einer Höhe unter der der oberen Oberfläche (10A) des Siliziumwafers (10) mit einem leitenden Material (15), das sich zur Verwendung als die Gateelektrode des Transistors eignet;
Ausbilden einer Dielektrikumsschicht (18) über dem Graben (13), um den Graben (13) im Wesentlichen bis zu der Höhe der oberen Oberfläche (10A) des Siliziumwafers (10) zu füllen;
Ausbilden von Gebieten der Sourceelektrode (20, 22) und Drainelektrode (21) in dem Siliziumwafer (10) auf gegenüberliegenden Seiten des Grabens (13) des Siliziumwafers (10);
Ausbilden einer epitaxialen Schicht (25A, 25B) aus dotiertem Silizium über dem Gebiet der Sourceelektrode (20, 22), um als die untere Platte des Speicherkondensators zu dienen, und Ausbilden einer epitaxialen Schicht (25C) aus dotiertem Silizium über dem Gebiet der Drainelektrode (21), um als ein Bitleitungskontakt zu dem Gebiet der Drainelektrode (21) zu dienen;
Ausbilden einer Schicht (29) über dem Gebiet der Sourceelektrode (20, 22), die sich zur Verwendung als die Dielektrikumsschicht des Speicherkondensators eignet; und
Ausbilden einer leitenden Schicht (30), die sich zur Verwendung als die obere Platte des Kondensators eignet, über der Dielektrikumsschicht (29) des Speicherkondensators.

7. Verfahren nach Anspruch 6, bei dem das leitende Material (15), das sich zur Verwendung als die Gateelektrode eignet, einen inneren Kern (17) aus einem Silizid, von dotiertem Polysilizium (15) umgeben, umfasst.

8. Verfahren nach Anspruch 6, bei dem der aktive Bereich von einem mit einem dielektrischen Material gefüllten umgebenden Graben definiert wird.

9. Verfahren nach Anspruch 6, bei dem ein Paar von Gräben in dem aktiven Bereich ausgebildet ist und ein Gebiet einer gemeinsamen Drainelektrode (21) in dem Gebiet zwischen den beiden Gräben ausgebildet ist und separate Gebiete der Sourceelektrode (20, 22) in den beiden Gebieten außerhalb der beiden Gräben ausgebildet sind und jeder der Gräben ähnlich gefüllt ist.

10. Verfahren nach Anspruch 9, bei dem der aktive Bereich durch einen mit Siliziumoxid gefüllten umgebenden Isolationsgraben definiert wird.

11. Verfahren nach Anspruch 9, bei dem jeder der beiden Gräben ähnlich mit einem inneren Kern (17) aus einem Silizid und einer umgebenden Schicht aus dotiertem Polysilizium (15) gefüllt wird.

12. Verfahren nach Anspruch 6, bei dem jede der dotierten epitaxialen Siliziumschichten (25A, 25B, 25C) über den beiden Gebieten der Sourceelektroden (20, 22) mit einer Dielektrikumsschicht (29) und einer leitenden Schicht (30) bedeckt ist, um separate Speicherkondensatoren auszubilden.

## Revendications

1. Cellule de mémoire comprenant un transistor en série avec un condensateur de stockage à utiliser dans une matrice de cellules de mémoire qui forme une mémoire vive dynamique comprenant :
un corps (10) semiconducteur d'un type de conductivité ayant une surface (10A) de sommet ;
des première et deuxième régions du type de conductivité opposées à celui du corps semiconducteur, aptes à servir comme source (20, 22) et drain (21) du transistor et formées dans le corps (10) semiconducteur et étant à distance par une partie du corps semiconducteur et ayant chacune l'une de leur partie qui comprend une partie de la surface (10A) de sommet ;
un sillon (13) dans le corps (10) semiconducteur dans la région intermédiaire entre les régions à distance, le sillon (13) comprenant un remplissage (15) conducteur, le niveau du remplissage (15) conducteur étant plus bas que celui de la surface (10A) de sommet du corps (10) semiconducteur, le remplissage (15) conducteur étant isolé électriquement du corps (10) semiconducteur autour par une couche d'un matériau (14A, 14B, 14C) propre à servir de diélectrique de grille du transistor et comprenant une couche (18) diélectrique au dessus qui forme une surface planaire avec la surface (10A) de sommet ; et
un condensateur de stockage, placé au dessus du corps (10) semiconducteur et comprenant une couche (25A, 25B, 25C) conductrice sur la région de source (20, 22) pour servir de plateau inférieur, une couche (29) de matériau propre à un diélectrique de condensateur au dessus du plateau (25A, 25B, 25C) inférieur et une couche (30) conductrice au dessus du diélectrique de condensateur pour servir de plateau supérieur ;
dans laquelle les régions de source (20, 22) et de drain (21) comprennent une couche (25A, 25B, 25C) épitaxiale de silicium dopé, que l'on a fait croître sur la surface d'origine du corps (10) semiconducteur pour servir de plateau inférieur du condensateur de stockage.

2. Cellule de mémoire suivant la revendication 1 dans laquelle le remplissage (15) conducteur du sillon est du polysilicium dopé et le diélectrique (14A, 14B, 14C) autour est de l'oxyde de silicium.

3. Cellule de mémoire suivant la revendication 2 dans laquelle le remplissage (15) conducteur du sillon comprend un noyau (17) en siliciure.

4. Cellule de mémoire suivant la revendication 1 dans laquelle une couche de siliciure (27A, 27B, 27C) surmonte la couche (25A, 25B, 25C) épitaxiale de silicium dopé.

5. Cellule de mémoire suivant la revendication 1 dans laquelle le corps (10) semiconducteur est en silicium monocristallin, et
dans laquelle le sillon (13) comprend des parties de paroi et de fond de polysilicium dopé et une région (17) de noyau en un matériau très conducteur, la région (17) de noyau servant de prise de contact de grille.

6. Procédé pour former une cellule de mémoire qui comprend un transistor et un condensateur de stockage, comprenant les stades dans lesquels :
on définit, dans une partie de surface d'une tranche (10) de silicium monocristallin, une zone active dans laquelle il faut former un transistor de commutation ;
on forme un sillon (13) dans une région intermédiaire de cette partie de surface ;
on recouvre le sillon (13) d'une couche (14A, 14B, 14C) diélectrique propre à être utilisée comme diélectrique de grille du transistor ;
on remplit partiellement le sillon (13) jusqu'à un niveau en dessous de la surface (10A) de sommet de la tranche (10) de silicium d'un matériau (15) conducteur propre à être utilisé comme électrode de grille du transistor ;
on forme une couche (18) diélectrique sur le sillon (13) essentiellement jusqu'au niveau de la surface (10A) de sommet de la tranche (10) de silicium ;
on forme des régions de source (20, 22) et de drain (21) dans la tranche (10) de silicium sur des côtés opposés du sillon (13) de la tranche (10) de silicium ;
on forme une couche (25A, 25B) épitaxiale de silicium dopé sur la région de source (20, 22) pour servir de plateau inférieur du condensateur de stockage et on forme une couche (25C) épitaxiale dopée sur la région de drain (21) pour servir de contact de ligne de bit avec la région de drain (21) ;
on forme sur la région de source (20, 22) une couche (29) propre à être utilisée comme couche diélectrique du condensateur de stockage ; et
on forme sur la couche (29) diélectrique du condensateur de stockage une couche (30) conductrice propre à être utilisée comme plateau supérieur du condensateur.

7. Procédé suivant la revendication 6 dans lequel le matériau (15) conducteur propre à être utilisé comme électrode de grille comprend un noyau (17) intérieur de siliciure entouré de polysilicium (15) dopé.

8. Procédé suivant la revendication 6 dans lequel la zone active est définie par un sillon tout autour empli d'un matériau diélectrique.

9. Procédé suivant la revendication 6 dans lequel on forme une paire de sillons dans la zone active et on forme une région commune de drain (21) dans la région intermédiaire entre les deux sillons et on forme des régions distinctes de source (20, 22) dans les deux régions à l'extérieur des deux sillons et on remplit de la même façon chacun des sillons.

10. Procédé suivant la revendication 9 dans lequel on définit la zone active par un sillon isolant tout autour rempli d'oxyde de silicium.

11. Procédé suivant la revendication 9 dans lequel on remplit de la même façon chacun des deux sillons par un noyau (17) intérieur d'un siliciure et par une couche tout autour de poly silicium (15) dopé.

12. Procédé suivant la revendication 6 dans lequel on recouvre chacune des couches épitaxiales (25A, 25B, 25C) de silicium dopé sur les deux régions de source (20, 22) d'une couche (29) diélectrique et d'une couche (30) conductrice pour former des condensateurs de stockage distincts.
